# EUROPEAN PATENT SPECIFICATION

(11) **EP 3 150 909 B1**
(45) Date of publication and mention of the grant of the patent: **04.11.2020**
(21) Application number: 15799611.7
(22) Date of filing: 27.05.2015
(51) Int. Cl.: F21V 7/24, G02B 5/02, F21K 9/64, G02B 1/11, F21V 13/08, F21V 7/22, H01L 33/50, F21S 8/00, F21V 9/40, F21V 9/30, C09K 11/02

(54) **WAVELENGTH CONVERSION DEVICE AND RELATED LIGHT-EMITTING DEVICE THEREOF**
WELLENLÄNGENUMWANDLUNGSVORRICHTUNG UND ZUGEHÖRIGE LICHTEMITTIERENDE VORRICHTUNG DAMIT
DISPOSITIF DE CONVERSION DE LONGUEUR D'ONDE ET SON DISPOSITIF ÉLECTROLUMINESCENT ASSOCIÉ

(30) Priority: 28.05.2014 CN 201410230623
(43) Date of publication of application: 05.04.2017
(73) Proprietor: Appotronics Corporation Limited, Shenzhen, Guangdong (CN)
(72) Inventor: LI, Qian, Shenzhen, Guangdong 518055 (CN); XU, Yanzheng, Shenzhen, Guangdong 518055 (CN); TIAN, Zifeng, Shenzhen, Guangdong 518055 (CN); CHEN, Yusan, Shenzhen, Guangdong 518055 (CN)
(74) Representative: Gulde & Partner
(86) International application number: PCT/CN2015/079868
(87) International publication number: WO 2015/180630

(56) References cited:
- CN-A- 101 225 942
- CN-A- 102 419 468
- CN-A- 102 473 824
- CN-A- 102 782 082
- CN-A- 103 026 785
- CN-A- 104 566 229
- CN-U- 203 489 180
- CN-U- 203 489 180
- KR-A- 20040 078 188
- US-A1- 2012 320 601
- US-B2- 8 614 539

## Description

### BACKGROUND OF THE INVENTION

### Field of the Invention

This invention relates to display and illumination technologies, and in particular, it relates to a wavelength conversion device and related light emitting device.

### Description of Related Art

With the development of display and illumination technologies, conventional LED and halogen light sources are increasingly unsatisfactory for the high power and high brightness requirements of display and illumination applications. A technology using a solid state light source such as laser diode (LD) to generate an excitation light to excite wavelength conversion materials can generate visible light of various colors, and this technology has been increasingly used in illumination and display fields. This technology has the advantages of high efficiency, low energy consumption, low cost, and long life, and is currently being used in white and monochromatic light sources.

In current technologies, in light sources where laser excitation lights are used to excite wavelength conversion materials, in order to improve light utilization efficiency, reflective type devices are commonly used, where the light passes through a sheet of wavelength conversion material (i.e. the light emitting layer) to be incident on a reflective plate (i.e. reflective layer and substrate), and is reflected back to the wavelength conversion material sheet. This ensures that the light is output in the same direction, and prevents light loss due to scattering of the wavelength conversion material sheet. In current technologies, the reflective plate typically employs a metal plate as the substrate, such as aluminum, aluminum alloy, copper, etc., where the metal substrate is stacked with a high reflective film. The high reflective film typically employs high purity aluminum or high purity silver as a coating layer. The wavelength conversion material is sealed using a silica gel or a resin or other transparent organic material as a sealing medium; the wavelength conversion material is mixed with the silica gel or resin and then coated on the metal substrate to form the light emitting layer. However, because silica gel and resin have relatively poor isolation ability for air, the air can penetrate the wavelength conversion material layer to come into contact with the reflective layer on the substrate, so that the reflective layer is exposed to the air. When the reflective layer is made of silver, the silver atoms tend to react with the hydrogen sulfide and oxygen in the air in a vulcanization or oxidation reaction. As a result, the reflectivity and thermal stability of the reflective layer can decrease significantly, and the silver layer can even become dark, so the effectiveness of the reflective layer is significantly reduced. For aluminum reflective layers, while the stability of aluminum is higher than that of silver, its reflectivity is not as high, so it absorbs more light and generates more heat as compared to silver layers.

Because of the above shortcomings of metal reflective layers discussed above, the inventor searched for reflective layers that have high thermal stability and high reflectivity, and discovered that white inorganic materials such as aluminum oxide and other metal oxides have relatively high reflectivity, and have high temperature resistance and can satisfy the thermal stability requirement of high power laser illumination. However, to achieve sufficiently high reflectivity (e.g., above 90% reflectivity for visible light), the reflective layer needs to have a sufficient thickness; on the other hand, increased thickness of the reflective layer results in a reduction of the thermal conductivity of the reflective layer, and therefore, the light emission efficiency of the light emitting layer of the wavelength conversion device will decrease due to heat accumulation. Therefore, there is a need for a reflective layer having high reflectivity and small thickness.

Furthermore, CN 203 489 180 U discloses a wavelength conversion device comprising a substrate, a reflective layer, and a light emitting layer, wherein the reflective layer is a total reflection film. Furthermore, US 2012/320601 A1 is directed to an illumination device comprising a mounting substrate on which LED chips are mounted, wherein a reflective layer is formed on the front of the substrate.

### SUMMARY

Accordingly, the present invention is directed to a wavelength conversion device, which employs a high reflective and thin reflective layer.

The present invention provides a wavelength conversion device, which includes a substrate, a reflective layer, and a light emitting layer stacked successively, wherein the reflective layer contains reflective particles, auxiliary particles, and a first binder, the reflective particles reflecting light, the auxiliary particles filling voids between the reflective particles, and the first binder binding the reflective particles and the auxiliary particles to form the layer,wherein the light emitting layer contains a wavelength conversion material and a second binder, and wherein the reflective particles are aluminum oxide particles and the auxiliary particles are titanium oxide particles. A thickness of the reflective layer is less than 70 µm and a reflectivity of the reflective layer for visible light is higher than 95%.

Preferably, a mass fraction of the auxiliary particles in the reflective layer is 40-75%, and a mass fraction of the reflective particles in the reflective layer is 0.5-30%.

Preferably, a particle diameter of the titanium oxide particles is 0.02-1 µm, and a particle diameter of the aluminum oxide particles is 0.01- 1 µm. More preferably, the particle diameter of the titanium oxide particles is 0.2-0.5 µm, and the particle diameter of the aluminum oxide particles is 0.02-0.7 µm.

Preferably, the thickness of the reflective layer is more than 30 µm and the reflectivity of the reflective layer for visible light is higher than 95%.

Preferably, a porosity of the reflective layer is less than 35%.

Preferably, the first binder is a first glass powder, and wherein a mass fraction of the first glass powder in the reflective layer is 20-50%.

Preferably, the first glass powder is SiO₂-B₂O₃-RO, wherein R is one or more selected from Mg, Ca, Sr, Ba, Na, and K.

Preferably, the reflective layer is formed by sintering a mixture of the reflective particles, the auxiliary particles, the first glass powder, and an organic carrier, wherein the organic carrier is a mixture of ethyl cellulose, terpineol and butyl carbitol or is a silicone oil, and wherein a residue of the organic carrier in the reflective layer has a mass fraction of 0.001-0.1%.

Preferably, the second binder is a second glass powder, which is one or more selected from SiO₂-B₂O₃-RO, SiO₂-TiO₂-Nb₂O₅-R'₂O, and ZnO-P₂O₅, wherein R is one or more selected from Mg, Ca, Sr, Ba, Na, and K, and wherein R' is one or more selected from Li, Na and K.

Preferably, the first binder is a silica gel or a resin. Preferably, the auxiliary particles are titanium oxide particles pre-treated with a coupling agent, wherein the coupling agent is a silane coupling agent or ethyl orthosilicate.

Preferably, the second binder is a silica gel or a resin.

Preferably, a volume fraction of the wavelength conversion material in the light emitting layer is 30-75%, and a volume fraction of the second binder in the light emitting layer is 25-70%. More preferably, the volume fraction of the wavelength conversion material in the light emitting layer is 35-55%, and the volume fraction of the second binder in the light emitting layer is 45-65%.

Preferably, a thickness of the light emitting layer is 50-300 µm.

Preferably, the substrate is an aluminum nitride substrate, or the substrate is a metal substrate.

Preferably, the wavelength conversion device further includes an antireflection film located on a side of the light emitting layer facing away from the reflective layer.

Preferably, the wavelength conversion device further includes a glass layer formed from a third glass powder, located between the light emitting layer and the antireflection film.

Preferably, a thickness of the glass layer is 20-50 µm.

In another aspect, the present invention provides a light emitting device, which includes an excitation light source, and preferably includes any of the above wavelength conversion devices.

Compared to conventional technology, embodiments of the present invention have the following advantages:
In embodiments of the present invention, by employing a structure including reflective particles, auxiliary particles and first binder to form the reflective layer of the wavelength conversion device, the reflective particles are used to achieve reflection, and the auxiliary particles are used to fill the voids between the reflective particles. This fills the voids between the reflective particles, reduces the penetration depth of the light into the reflective layer; it ensures a high reflectivity of the reflective layer and reduces the thickness of the reflective layer. As a result, the wavelength conversion device has high light utilization efficiency and good heat dissipation.

### BRIEF DESCRIPTION OF THE DRAWINGS

Figure 1 illustrates the structure of a wavelength conversion device according to a first embodiment of the present invention.
Figure 2 illustrates the structure of a wavelength conversion device according to a second embodiment of the present invention.
Figure 3 illustrates the structure of a wavelength conversion device according to a third embodiment of the present invention.

### DETAILED DESCRIPTION OF PREFERRED EMBODIMENTS

Embodiments of the present invention are described below with reference to the drawings. For clarity, the terms "up" and "down" in the descriptions below refer to the up and down direction of the drawings.

### First embodiment

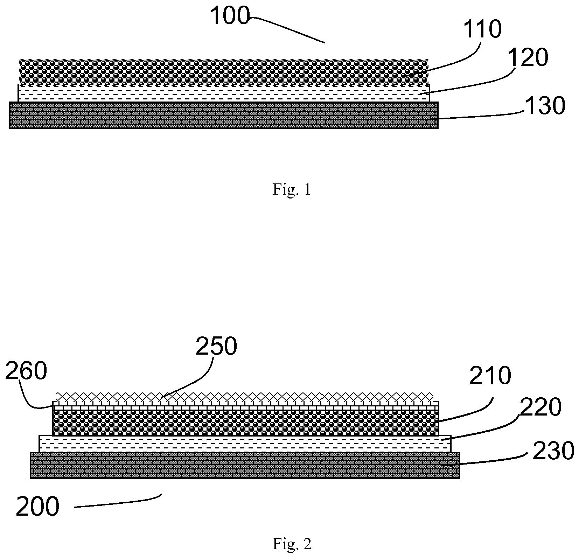

Refer to Fig. 1, which illustrates the structure of a wavelength conversion device according to a first embodiment of the present invention. As shown in the figure, the wavelength conversion device 100 includes a substrate 130, a light emitting layer 110, and a reflective layer 120. The reflective layer 120 includes reflective particles, auxiliary particles, and a first binder. The light emitting layer 110 includes a wavelength conversion material and a second binder.

As discussed in the background section, the light emitted by the light emitting layers is incident on the reflective layer, and reflected by it back to the light emitting layer. The heat generated by the light emitting layer is transmitted by the reflective layer to the substrate, and then dissipated.

In the wavelength conversion device 100, the reflective layer 120 has two functions, namely, light reflection and heat conduction. The reflective layer 120 should have a relatively high reflectivity, to ensure high light utilization efficiency; the reflective layer 120 should also have superior thermal conductivity. The thinner the reflective layer, the better its thermal conduction effect.

As mentioned above, the reflective layer 120 includes reflective particles, auxiliary particles, and a first binder. The reflective particles are particles that have high reflectivity, in particular, particles that have reflectivity above 90% for visible light in the 400-800 nm wavelength range, and that have particle diameters smaller than or equal to 2 µm. Reflective particles having such properties may include aluminum oxide, barium sulfate, zinc oxide, boron nitride, etc.

Auxiliary particles are particles that have good covering property, high dispersibility, do not tend to agglomerate, so that they can sufficiently mix with and disperse the reflective particles. These properties ensure that the reflective particles can sufficiently and uniformly spread out, so that they can achieve superior reflectivity without being overly thick. A reflective layer that only consists of the auxiliary particles will have low reflectivity in the range 80-85% and cannot meet the functional requirement of a reflective layer, but as long as reflective particles are added in the amount of, e.g., 20% of the weight of the auxiliary particles, the reflectivity of the layer can be increased to above 95% (for layers of the same thickness). The particle diameters of the auxiliary particles are typically smaller than or equal to 1 µm. Auxiliary particle having such properties may be, for example, titanium oxide.

In this embodiment, the reflective particles are aluminum oxide (Al₂O₃) particles, and the auxiliary particles are titanium oxide (TiO₂) particles. Aluminum oxide has superior reflectivity for visible light, where a pure aluminum oxide layer has a reflectivity as high as 90% for visible light. However, because there are large voids between aluminum oxide particles, the light can penetrate through between aluminum oxide particles. Thus, a layer of relatively thick aluminum oxide stack is required to achieve the above mentioned reflectivity. The thicker the aluminum oxide layer, the poorer the thermal conductivity of the layer. Titanium oxide itself has certain reflectivity, in particular, it has good reflectivity for light having a wavelength above 550 nm. However, titanium oxide has relatively poor reflectivity for light having a wavelength below 480 nm, and cannot meet the requirements of a reflective layer. By combining aluminum oxide and titanium oxide, it was discovered that it is very easy to form a thin film with the mixture layer; the titanium oxide particles fill the voids between the aluminum oxide particles, and at the same time ensure that the light traveling between aluminum oxide particles is reflected back due to the reflective property of the titanium oxide particles. As a result, the mixture layer can achieve relatively high reflectivity even with a relatively thin thickness. Further, compared to aluminum oxide, titanium oxide has a higher wettability for the softened binder (such as glass powder), and does not tend to form closed air bubbles inside.

In a preferred embodiment, the porosity of the reflective layer is less than 35%. When the porosity of the reflective layer is relatively high, the reflective layer has a loose structure, with a relatively large thickness; further, the thermal conductivity of pores is very poor, causing the entire reflective layer to have poor thermal conductivity.

In the reflective layer 120, when the amount of aluminum oxide is too much or the amount of titanium oxide is too little, the reflective layer 120 is not sufficiently compact, and will require a relatively large thickness to achieve sufficient reflectivity. When the amount of aluminum oxide is too little or the amount of titanium oxide is too much, the reflectivity of light at the particle surface of the reflective layer 120 is not sufficiently high, and also cannot achieve required reflectivity. It was shown by experiments that when the mass fraction of aluminum oxide in the reflective layer 120 is 0.5-30%, and the mass fraction of titanium oxide in the reflective layer 120 is 40-75%, the reflective layer has both superior reflectivity and relatively thin thickness.

In the reflective layer 120, the larger the particle diameters of the reflective particles, the poorer its reflectivity; but the smaller the particle diameters of the reflective particles, the harder it is to disperse them and the more likely they are to agglomerate. Meanwhile, the suitable size of the auxiliary particles should be determined by the particle diameter of the reflective particles in order to achieve the function of filling the voids and reducing the required thickness. I.e., the particle diameter difference between the auxiliary particles and reflective particles should be relatively small. In one preferred embodiment, the particle diameter of the aluminum oxide particles is 0.01-1 µm, and more preferably, 0.02-0.7 µm; the particle diameter of the titanium oxide particles is 0.02-1 µm, and more preferably, 0.2-0.5 µm.

In this embodiment, the thicker the reflective layer 120, the higher the thermal resistance of the reflective layer. Those of ordinary skill in the relevant art can determine the thickness of the reflective layer 120 based on the teaching of this disclosure. In one preferred embodiment, the thickness of the reflective layer 120 is smaller than 70 µm, and its reflectivity for visible light is higher than 95%. More preferably, the thickness of the reflective layer 120 is 30-70 µm, and its reflectivity for visible light is still higher than 95%. When the thickness of the reflective layer is greater than 70 µm, the effect of thickness on reflectivity is insignificant. When the thickness of the reflective layer is less than 20 µm, the reflectivity drops significantly. Embodiments of the present invention can achieve a reflective layer which ensures its reflectivity function and reduces its thickness. As a result, the thermal resistance of the reflective layer 120 is low, the material cost is reduced, and the weight of the wavelength conversion device is also reduced.

The reflective layer 120 of the present embodiment includes, in addition to the reflective particles and auxiliary particles, a first binder. The first binder binds the reflective particles and the auxiliary particles to form a layer. Because the reflective particles and auxiliary particles by themselves do not bind to each other, even if they can be staked or piled into a layer, the layer structure can be easily destroyed by external forces or during movement. Therefore, the first binder is used to ensure that the reflective particles and the auxiliary particles form a stable structure.

In this embodiment, the first binder in the reflective layer 120 is a resin or silica gel. The resin or silica gel becomes a flowable semi-solid when heated, and can permeate the voids between the reflective particles and the auxiliary particles, and coat the exterior of the reflective particles and the auxiliary particles to form a layer. In a preferred embodiment, the surface of the titanium oxide is pre-treated with ethyl orthosilicate, to improve its compatibility with the silica gel or the resin, thereby enhancing the coating of the particles by the silica gel or the resin. A silane coupling agent can be used to achieve the same effect. A silane coupling agent has an organic group at one end and an inorganic group at the other end, and can effectively couple the titanium oxide and the silica gel.

In this embodiment, the light emitting layer 110 includes a wavelength conversion material and a second binder. The second binder is a resin or silica gel. Because the light emitting layer 110 and the reflective layer 120 use the same type of materials as the binders, it facilitates the integration of the two. The first binder and the second binder may be the same resin or silica gel, or different resins or silica gels.

In this embodiment, the substrate 130 is a metal substrate, such as copper, aluminum or aluminum alloy substrate. It can withstand certain temperatures, and has superior thermal conductivity and machinability, and can achieve high performance under low power laser light source (<50W) conditions. The substrate 130 may also be high thermal conductivity ceramics; compared to metal substrates, ceramic substrates have better heat resistance, and are suitable under conditions of medium to high power laser sources.

An alternative embodiment of the first embodiment is shown in Fig. 1, where the wavelength conversion device 100 has the same structure as that in the first embodiment, the difference from the first embodiment being that the materials used in the light emitting layer 110, the reflective layer 120 and the substrate 130 of the wavelength conversion device 100 are different from the first embodiment.

In this embodiment, the first binder in the reflective layer 120 is a first glass powder. Compared to resin and silica gel, glass powders have better temperature resistance, and can satisfy the requirements of high temperature treatment processing of the wavelength conversion device. In this embodiment, the first glass powder is preferably SiO₂-B₂O₃-RO (R being one or more selected from Mg, Ca, Sr, Ba, Na, and K). This type of glass powders have superior optical properties, and can reduce the loss when the light travels in the reflective layer, and therefore reducing the heat generated in the reflective layer. Further, this type of glass powders has low fluidity in the range within 200°C above the softening point, which ensures that the reflective layer 120 can maintain its smooth morphology during high temperature treatment processing and will not deform, warp, bulge, etc.

In this embodiment, the first glass powder is about 20-50% of the total weight of the reflective layer 120. When the glass powder is less than 20%, it will not sufficiently coat all of the reflective particles and auxiliary particles, so it cannot suitably bind and form the reflective layer. When the glass power is more than 50%, the reflective particles and the auxiliary particles will be too sparse, which is disadvantageous for reflecting the incident light by the reflective layer.

In this embodiment, the reflective layer 120 is formed by sintering a mixture of the reflective particles, the auxiliary particles, the first glass powder, and an organic carrier. The organic carrier is used to prepare a slurry for the reflective layer, enabling the reflective particles, the auxiliary particles and the first glass powder to fully mix and disperse in a liquid phase, and also giving the slurry certain fluidity so as to enable the coating and forming of the reflective layer on the substrate. The organic carrier should have sufficient wettability for the reflective particles, the auxiliary particles and the first glass powder. Further, the organic carrier should be completely decomposed and discharged during the high temperature treatment process. In this embodiment, the organic carrier is a mixture of ethyl cellulose, terpineol and butyl carbitol. The organic carrier may alternatively be a silicone oil. Through extensive experimentation, it was determined that the mixture of ethyl cellulose, terpineol and butyl carbitol or the silicone oil has good wettability and dispersibility, and can be almost completely decomposed and discharged in the temperature range of 360-420°C. It is possible that a portion of the organic carrier is surrounded by the reflective particles, the auxiliary particles and the first glass powder and cannot be discharged, and it can have a side reaction with the reflective particles, the auxiliary particles or the first glass powder in the subsequent high temperature treatment process. As a result, the formed reflective layer may contain a residue of the organic carrier, and its mass fraction may be 0.001-0.1%.

In this embodiment, the second binder in the light emitting layer 110 is a second glass powder. The second glass powder is a glass powder that has high transparency, low light absorption, and high thermal conductivity. The high transparency facilitates the light input and output. The low light absorption reduces light loss when the light is reflected back and forth multiple times within the light emitting layer. The high thermal conductivity facilitates heat conduction and lowers the working temperature of the light emitting layer. The second glass powder may be one or more selected from SiO₂-B₂O₃-RO, SiO₂-TiO₂-Nb₂O₅-R'₂O, and ZnO-P₂O₅, where R is one or more selected from Mg, Ca, Sr, Ba, Na, and K, and R' is one or more selected from Li, Na and K.

In this embodiment, the first binder in the reflective layer 120 and the second binder in the light emitting layer 110 are both glass powders, which helps the integration of the two layers, and also ensures that the overall wavelength conversion device 100 is high temperature resistant.

In this embodiment, in the light emitting layer 110, if the volume fraction of the wavelength conversion material is too large and the volume fraction of the second glass powder is too small, it will be difficult for the light emitting layer to be bound into a layer. On the other hand, if the volume fraction of the wavelength conversion material is too small, its light emitting efficiency will be low. In this embodiment, to take into consideration both the light emitting efficiency and the layer formation of the light emitting layer, the volume fraction of the wavelength conversion material in the light emitting layer is 30-75%, and the volume fraction of the second binder in the light emitting layer is 25-70%. In a preferred embodiment, the volume fraction of the wavelength conversion material in the light emitting layer is 35-55%, and the volume fraction of the second binder in the light emitting layer is 45-65%.

In this embodiment, to ensure light emitting efficiency of the light emitting layer 110, the layer should have a sufficient thickness, so that the light travels inside the light emitting layer for a distance that allows wavelength conversion to occur sufficiently. However, the light emitting layer 110 should not be too thick, to prevent poor thermal conductivity and poor heat dissipation. In this embodiment, the thickness of the light emitting layer 110 is 50-300 µm.

In this embodiment, the substrate 130 is an aluminum nitride ceramic substrate, which has good thermal conductivity and mechanical strength, so that it will not degrade under high temperature and its deformation is minimal. Further, the differences in thermal expansion coefficients between aluminum nitride and titanium oxide and aluminum oxide are small. Moreover, the aluminum nitride substrate is resistant to high temperature. All of the above make it suitable for applications using medium and high power laser sources (>100W). In this embodiment, the substrate 130 is prepared using a tape casting method. Its relative density is greater than 95%, and its thermal conductivity is greater than 150W/mK. Further, the substrate 130 may alternatively be made of aluminum oxide, silicon carbide, silicon nitride, boron nitride, or beryllium oxide ceramics; such substrates have similar properties as the aluminum nitride substrate.

### Second embodiment

Refer to Fig. 2, which illustrates the structure of a wavelength conversion device according to a second embodiment of the present invention. In the wavelength conversion device 200 of this embodiment, the light emitting layer 210, the reflective layer 220 and the substrate 230 are the same as those of the first embodiment and will not be described in further detail. A difference from the first embodiment is that, as shown in Fig. 2, the wavelength conversion device 200 further includes a glass layer 260 and an antireflection film 250.

The glass layer 260 is located on the light emitting layer 210, and is formed from a third glass powder. Because the surface of the light emitting layer 210 may have a small amount of wavelength conversion material particles that protrude from the surface, coating directly on such a surface may cause the coated film to be non-smooth. But if the light emitting layer is polished before coating, the light emitting layer may be damaged by the polishing step. Pure glass is very easy to polish and can give flat and smooth surfaces, which facilitates the coating process. If the glass layer 260 is too thin, its thickness uniformity will be difficult to control; but if the glass layer 260 is too thick, it may adversely impact the transmission of light. Through experimentation, it was determined that a thickness of the glass layer 260 of 20-50 µm can both ensure uniformity and avoid adverse impact on the light transmission (the reduction of light transmission is less than 1%).

The antireflection film 250 is located on the glass layer 260, for reducing the light reflection at the interface and enhancing the light transmission, which increases light utilization efficiency. The antireflection film may be SiO₂ or MgF₂, and its thickness may be between 50nm and 150 nm.

In this embodiment, adding the glass layer 260 is a preferred implementation; alternatively, the antireflection film 250 may be directly coated on the light emitting layer 210. However, as explained above, direct coating may cause the film to be non-smooth.

### Third embodiment

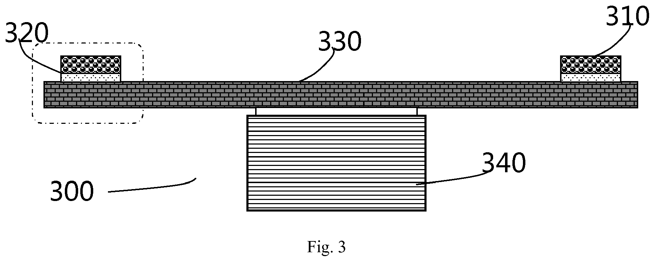

Refer to Fig. 3, which illustrates the structure of a wavelength conversion device according to a third embodiment of the present invention. In the wavelength conversion device 300 of this embodiment, the light emitting layer 310, the reflective layer 320 and the substrate 330 are the same as those of the first embodiment and will not be described in further detail. A difference from the first embodiment is that this embodiment further includes a drive device 340. Specifically, the drive device 340 is a drive motor. The substrate 330 in this embodiment is a round substrate, which carries the ring shaped reflective layer 320 and light emitting layer 310. The drive device 340 is fixedly coupled to the substrate 330. When the drive device 340 rotates, it drives the substrate 330 and the reflective layer 320 and the light emitting layer 310 on the substrate to rotate. This avoids the problem when the laser from the excitation light source continuously illuminates on the same point of the light emitting layer for prolonged time periods which can cause the wavelength conversion material on that point of the light emitting layer 310 to be quenched.

The above descriptions disclose preferred embodiments of the present invention and do not limit the invention. It is intended that the present invention cover modifications and variations that come within the scope of the appended claims.

## Claims

1. A wavelength conversion device (100, 200, 300), comprising a substrate (130, 230, 330), a reflective layer (120, 220, 320), and a light emitting layer (110, 210, 310) stacked successively,
wherein the reflective layer (120, 220, 320) contains reflective particles for reflecting light, and
**characterized in that**
the reflective layer (120, 220, 320) further contains auxiliary particles for filling voids between the reflective particles, and a first binder for binding the reflective particles and the auxiliary particles to form the reflective layer (120, 220, 320), and
wherein the light emitting layer (110, 210, 310) contains a wavelength conversion material and a second binder,
the reflective particles are aluminum oxide particles and the auxiliary particles are titanium oxide particles,
wherein a thickness of the reflective layer (120, 220, 320) is less than 70 µm, and a reflectivity of the reflective layer (120, 220, 320) for visible light is higher than 95%.

2. The wavelength conversion device of claim 1, wherein a mass fraction of the auxiliary particles in the reflective layer (120, 220, 320) is 40-75%, and a mass fraction of the reflective particles in the reflective layer (120, 220, 320) is 0.5-30%.

3. The wavelength conversion device of claim 1, wherein a particle diameter of the titanium oxide particles is 0.02-1 µm, and a particle diameter of the aluminum oxide particles is 0.01- 1 µm.

4. The wavelength conversion device of any one of claim 1 to claim 3, wherein the first binder is a first glass powder, and wherein a mass fraction of the first glass powder in the reflective layer (120, 220, 320) is 20-50%.

5. The wavelength conversion device of claim 4, wherein the first glass powder is SiO₂-B₂O₃-RO, wherein R is one or more selected from Mg, Ca, Sr, Ba, Na, and K, and/or
wherein the second binder is a second glass powder, which is one or more selected from SiO₂-B₂O₃-RO, SiO₂-TiO₂-Nb₂O₅-R'₂O, and ZnO-P₂O₅, wherein R is one or more selected from Mg, Ca, Sr, Ba, Na, and K, and wherein R' is one or more selected from Li, Na and K.

6. The wavelength conversion device of any one of claim 1 to claim 3,
wherein the first binder is a silica gel or a resin, and/or
wherein the second binder is a silica gel or a resin.

7. The wavelength conversion device of any one of claim 1, claim 5 or claim 6, wherein a volume fraction of the wavelength conversion material in the light emitting layer (110, 210, 310) is 30-75%, and a volume fraction of the second binder in the light emitting layer (110, 210,310) is 25-70%.

8. The wavelength conversion device of any one of claim 1, claim 5 or claim 6, wherein a thickness of the light emitting layer (110, 210, 310) is 50-300 µm.

9. The wavelength conversion device of claim 1, wherein the substrate (130, 230, 330) is an aluminum nitride substrate, or the substrate is a metal substrate.

10. The wavelength conversion device of any one of claim 1 to claim 3, further comprising an antireflection film (250) located on a side of the light emitting layer (110, 210, 310) facing away from the reflective layer (120, 220, 320).

11. The wavelength conversion device of claim 10, further comprising a glass layer (260) formed from a third glass powder, located between the light emitting layer (110, 210, 310) and the antireflection film (250).

12. The wavelength conversion device of claim 11, wherein a thickness of the glass layer (260) is 20-50 µm.

13. A light emitting device, comprising an excitation light source and a wavelength conversion device (100, 200, 300) of any one of claims 1 through 12.

## Patentansprüche

1. Wellenlängenumwandlungsvorrichtung (100, 200, 300), umfassend ein Substrat (130, 230, 330), eine reflektierende Schicht (120, 220, 320) und eine lichtemittierende Schicht (110, 210, 310), die nacheinander gestapelt sind,
wobei die reflektierende Schicht (120, 220, 320) reflektierende Partikel zum Reflektieren von Licht enthält und
**dadurch gekennzeichnet, dass**
die reflektierende Schicht (120, 220, 320) ferner Hilfspartikel zum Füllen von Hohlräumen zwischen den reflektierenden Partikeln und ein erstes Bindemittel zum Binden der reflektierenden Partikel und der Hilfspartikel zur Bildung der reflektierenden Schicht (120, 220, 320) enthält, und
wobei die lichtemittierende Schicht (110, 210, 310) ein Wellenlängenumwandlungsmaterial und ein zweites Bindemittel enthält,
wobei es sich bei den reflektierenden Partikeln um Aluminiumoxidpartikel und bei den Hilfspartikeln um Titanoxidpartikel handelt,
wobei eine Dicke der reflektierenden Schicht (120, 220, 320) weniger als 70 µm beträgt und ein Reflexionsvermögen der reflektierenden Schicht (120, 220, 320) für sichtbares Licht höher als 95 % ist.

2. Wellenlängenumwandlungsvorrichtung nach Anspruch 1, wobei ein Massenanteil der Hilfspartikel in der reflektierenden Schicht (120, 220, 320) 40 - 75 % und ein Massenanteil der reflektierenden Partikel in der reflektierenden Schicht (120, 220, 320) 0,5 - 30 % beträgt.

3. Wellenlängenumwandlungsvorrichtung nach Anspruch 1, wobei ein Partikeldurchmesser der Titanoxidpartikel 0,02 - 1 µm und ein Partikeldurchmesser der Aluminiumoxidpartikel 0,01 - 1 µm beträgt.

4. Wellenlängenumwandlungsvorrichtung nach einem der Ansprüche 1 bis 3, wobei es sich bei dem ersten Bindemittel um ein erstes Glaspulver handelt und wobei der Massenanteil des ersten Glaspulvers in der reflektierenden Schicht (120, 220, 320) 20 - 50 % beträgt.

5. Wellenlängenumwandlungsvorrichtung nach Anspruch 4, wobei es sich bei dem ersten Glaspulver um SiO₂-B₂O₃-RO handelt, wobei es sich bei R um eines oder mehrere ausgewählt aus Mg, Ca, Sr, Ba, Na und K handelt, und/oder
wobei es sich bei dem zweiten Bindemittel um ein zweites Glaspulver handelt, das eines oder mehrere ausgewählt aus SiO₂-B₂O₃-RO, SiO₂-TiO₂-Nb₂O₅-R'₂O und ZnO-P₂O₅ ist, wobei es sich bei R um eines oder mehrere ausgewählt aus Mg, Ca, Sr, Ba, Na und K und bei R' um eines oder mehrere ausgewählt aus Li, Na und K handelt.

6. Wellenlängenumwandlungsvorrichtung nach einem der Ansprüche 1 bis 3,
wobei es sich bei dem ersten Bindemittel um ein Kieselgel oder ein Harz handelt, und/oder
wobei es sich bei dem zweiten Bindemittel um ein Kieselgel oder ein Harz handelt.

7. Wellenlängenumwandlungsvorrichtung nach einem der Ansprüche 1, 5 oder 6, wobei ein Volumenanteil des Wellenlängenumwandlungsmaterials in der lichtemittierenden Schicht (110, 210, 310) 30 - 75 % und ein Volumenanteil des zweiten Bindemittels in der lichtemittierenden Schicht (110, 210, 310) 25 - 70 % beträgt.

8. Wellenlängenumwandlungsvorrichtung nach einem der Ansprüche 1, 5 oder 6, wobei die Dicke der lichtemittierenden Schicht (110, 210, 310) 50 - 300 µm beträgt.

9. Wellenlängenumwandlungsvorrichtung nach Anspruch 1, wobei es sich bei dem Substrat (130, 230, 330) um ein Aluminiumnitridsubstrat handelt oder das Substrat ein Metallsubstrat ist.

10. Wellenlängenumwandlungsvorrichtung nach einem der Ansprüche 1 bis 3, die ferner einen Antireflexionsfilm (250) umfasst, der sich auf einer Seite der lichtemittierenden Schicht (110, 210, 310) befindet, die von der reflektierenden Schicht (120, 220, 320) abgewandt ist.

11. Wellenlängenumwandlungsvorrichtung nach Anspruch 10, die ferner eine Glasschicht (260) umfasst, die aus einem dritten Glaspulver gebildet wird und zwischen der lichtemittierenden Schicht (110, 210, 310) und dem Antireflexionsfilm (250) angeordnet ist.

12. Wellenlängenumwandlungsvorrichtung nach Anspruch 11, wobei die Dicke der Glasschicht (260) 20 - 50 µm beträgt.

13. Lichtemittierende Vorrichtung, umfassend eine Anregungslichtquelle und eine Wellenlängenumwandlungsvorrichtung (100, 200, 300) nach einem der Ansprüche 1 bis 12.

## Revendications

1. Dispositif de conversion de longueurs d'ondes (100, 200, 300) comprenant un substrat (130, 230, 330), une couche réfléchissante (120, 220, 320) et une couche émettrice de lumière (110, 210, 310) empilés en succession,
où la couche réfléchissante (120, 220, 320) contient des particules réfléchissantes pour réfléchir la lumière et
**caractérisé en ce que**
la couche réfléchissante (120, 220, 320) contient en outre des particules auxiliaires pour remplir les vides entre les particules réfléchissantes et un premier liant pour lier les particules réfléchissantes et les particules auxiliaires afin de former la couche réfléchissante (120, 220, 320) et
où la couche émettrice de lumière (110, 210, 310) contient un matériau de conversion de longueurs d'ondes et un second liant,
les particules réfléchissantes sont des particules d'un oxyde d'aluminium et les particules auxiliaires sont des particules d'un oxyde de titane,
où une épaisseur de la couche réfléchissante (120, 220, 320) est inférieure à 70 µm et un pouvoir réfléchissant de la couche réfléchissante (120, 220, 320) pour la lumière visible est supérieur à 95 %.

2. Dispositif de conversion de longueurs d'ondes de la revendication 1, où une fraction massique des particules auxiliaires dans la couche réfléchissante (120, 220, 320) est de 40-75 % et une fraction massique des particules réfléchissantes dans la couche réfléchissante (120, 220, 320) est de 0,5-30 %.

3. Dispositif de conversion de longueurs d'ondes de la revendication 1, où un diamètre particulaire des particules de l'oxyde de titane est de 0,02-1 µm et un diamètre particulaire des particules de l'oxyde d'aluminium est de 0,01- 1 µm.

4. Dispositif de conversion de longueurs d'ondes de l'une quelconque de la revendication 1 à la revendication 3, où le premier liant est une première poudre de verre et où une fraction massique de la première poudre de verre dans la couche réfléchissante (120, 220, 320) est de 20-50 %.

5. Dispositif de conversion de longueurs d'ondes de la revendication 4 où la première poudre de verre est SiO₂-B₂O₃-RO, où R représente un ou plusieurs sélectionnés parmi Mg, Ca, Sr, Ba, Na et K et/ou
où le second liant est une seconde poudre de verre qui est une ou plusieurs sélectionnées parmi SiO₂-B₂O₃-RO, SiO₂-TiO₂-Nb₂O₅-R'₂O et ZnO-P₂O₅, où R représente un ou plusieurs sélectionnés parmi Mg, Ca, Sr, Ba, Na et K et R' représente un ou plusieurs sélectionnés parmi Li, Na et K.

6. Dispositif de conversion de longueurs d'ondes de l'une quelconque de la revendication 1 à la revendication 3,
où le premier liant est un gel de silice ou une résine et/ou
où le second liant est un gel de silice ou une résine.

7. Dispositif de conversion de longueurs d'ondes de l'une quelconque de la revendication 1, la revendication 5 ou la revendication 6, où une fraction volumique du matériau de conversion de longueurs d'ondes dans la couche émettrice de lumière (110, 210, 310) est de 30-75 % et une fraction volumique du second liant dans la couche émettrice de lumière (110, 210, 310) est de 25-70 %.

8. Dispositif de conversion de longueurs d'ondes de l'une quelconque de la revendication 1, la revendication 5 ou la revendication 6, où une épaisseur de la couche émettrice de lumière (110, 210, 310) est de 50-300 µm.

9. Dispositif de conversion de longueurs d'ondes de l'une quelconque de la revendication 1, où le substrat (130, 230, 330) est un substrat de nitrure d'aluminium ou le substrat est un substrat métallique.

10. Dispositif de conversion de longueurs d'ondes de l'une quelconque de la revendication 1 à la revendication 3 comprenant en outre un film antireflet (250) sur une face de la couche émettrice de lumière (110, 210, 310) située à l'opposé de la couche réfléchissante (120, 220, 320).

11. Dispositif de conversion de longueurs d'ondes de la revendication 10 comprenant en outre une couche de verre (260) formée à partir d'une troisième poudre de verre, située entre la couche émettrice de lumière (110, 210, 310) et le film antireflet (250).

12. Dispositif de conversion de longueurs d'ondes de la revendication 11, où une épaisseur de la couche de verre (260) est de 20-50 µm.

13. Dispositif émetteur de lumière comprenant une source lumineuse d'excitation et un dispositif de conversion de longueurs d'ondes (100, 200, 300) de l'une quelconque des revendications 1 à 12.
